# EUROPEAN PATENT APPLICATION

(11) **EP 4 801 252 A1**
(43) Date of publication of application: **02.09.2026**
(21) Application number: 26155674.0
(22) Date of filing: 02.02.2026
(51) Int. Cl.: H10W 70/60

(54) **INTEGRATED CIRCUIT DEVICE PACKAGES WITH BUFFERING LAYER**

(30) Priority: 28.02.2025 US 202519067597
(71) Applicant: Avago Technologies International Sales Pte. Limited, Singapore 768923 (SG)
(72) Inventor: Wang, Tao, Los Gatos, CA 95032 (US)
(74) Representative: Grünecker Patent- und Rechtsanwälte PartG mbB

(57) **Abstract**

In an embodiment, a packaged integrated circuit device includes a package substrate. The package substrate may be flip-chip type package substrate. A layer is disposed on the package substrate. An interposer is disposed on the layer. This layer may have passthrough type through vias permitting electrical interconnections between the package substrate and the interposer. The interposer may have various wiring layers and circuit components therein. One or more dies are disposed on the interposer. A die may be an application specific integrated circuit devices, a high-speed memory device, or the like. The layer has a coefficient of thermal expansion that is between a coefficient of thermal expansion of the interposer and a coefficient of thermal expansion of the package substrate. The layer can function to intermediate stresses or strains arising during manufacturing and/or operation related to thermal expansion differences in components.

## Description

### BACKGROUND

Increasingly, integrated circuit devices are relying on larger and larger surface area designs for applications in artificial intelligence and high-performance computing. Certain flip-chip type packaging designs for these devices use an interposer element that is already several reticles in planar area size, for example, up to 4500 mm². Future devices will likely require even larger interposers as flip-chip substrates or overall planar package areas increase. The increased device sizes have generated challenges related to maintaining mechanical stability at interconnection joints between packaged elements as well overall package flatness under various thermal conditions experienced during manufacturing and assembly. Due to differences in internal package element thermal expansion properties, it can be difficult to maintain device interconnections, which may cause physical or electrical faults in the final device.

While it is somewhat possible to control element warpage by application of counteracting forces and/or stiffener elements in the device, there is a conflict between controlling package warpage by incorporation of flattening or stiffener elements and avoidance of internal stress in the packaged elements. This conflict generally worsens with larger planar area devices. As such, methods for addressing this issue are required for devices with large overall planar area sizes.

### SUMMARY

In an embodiment, a packaged integrated circuit device includes a package substrate, a layer disposed on the package substrate, an interposer disposed on the layer, and a die disposed on the interposer. The layer has a coefficient of thermal expansion that is between a coefficient of thermal expansion of the interposer and a coefficient of thermal expansion of the package substrate.

In an embodiment, a flip-chip packaged integrated circuit device includes a package substrate having first pads on a first surface and second pads on a second surface. The first pads are connected to the second pads by one or more wiring layers of the package substrate. The device further includes a layer mounted on the package substrate and having third pads on a third surface facing the package substrate and fourth pads on a fourth surface facing away from the package substrate. This layer has plurality of through-vias extending therethrough from the third surface to fourth surface to electrically connect the third pads to the fourth pads. An interposer is mounted on the layer and has fifth pads on a fifth surface facing the layer and sixth pads on a sixth surface facing away from the layer. The interposer incorporates therein one or more wiring layers electrically connecting the fifth pads to the sixth pads. A die is mounted on the interposer and has a seventh pad facing the interposer. The seventh pad is electrically connected to at least one of the first pads of the package substrate via at least one the plurality of through-vias.

In an embodiment, a method of manufacturing a packaged integrated circuit device comprises: mounting a layer on a package substrate, the package substrate having first pads on a first surface and second pads on a second surface, the first pads being electrically connected to the second pads by one or more wiring layers of the package substrate, the layer having third pads on a third surface facing the package substrate and fourth pads on a fourth surface facing away from the package substrate, a plurality of through-vias extending in the layer from the third surface to fourth surface to electrically connect the third pads to the fourth pads; mounting an interposer on the layer, the interposer having fifth pads on a fifth surface facing the layer and sixth pads on a sixth surface facing away from the layer, the interposer incorporating therein one or more wiring layers electrically connecting the fifth pads to the sixth pads; and mounting a die on the interposer. The ordering of mounting of components may differ from the sequence of the above in some examples.

As used in the present disclosure, terms such as "has," "with," "includes," or "including," when used in a manner such as component X has/with/includes component Y, is non-exclusive and open-ended so as to indicate component X comprises components Y such that other aspects, components, or elements other than component Y may also be a part of component X. Similarly, when an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection or coupling between the elements. However, the existence of a direct connection does not exclude other connections in which intervening elements may be present. Likewise, when an element is referred to herein as being "bonded to," "mounted on," "disposed on," or "on" another element, it is to be understood that such an element can be directly bonded to, mounted on, disposed on, or on the other element (without any intervening elements) or have intervening elements present between the bonded, mounted, or disposed elements. In contrast, when an element is referred to as being "directly bonded to," "directly mounted on," "directly disposed on," or "directly on" another element, it should be understood that no intervening elements are present.

### BRIEF DESCRIPTION OF THE DRAWINGS

Fig. 1 depicts a cross-sectional view of a package configuration of an embodiment.
Fig. 2 depicts a planar view of a package configuration of an embodiment.
Fig. 3 depicts a buffering layer of a first example.
Fig. 4 depicts a buffering layer of a second example.
Fig. 5 depicts a manufacturing method for a package configuration of an embodiment.
Fig. 6 depicts another manufacturing method for a package configuration of an embodiment.

### DETAILED DESCRIPTION

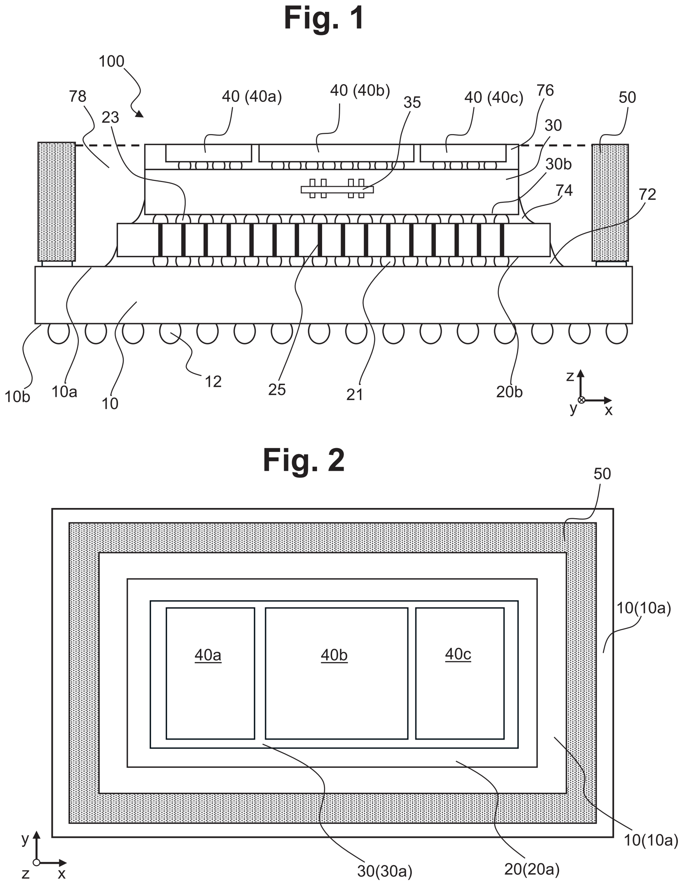

Fig. 1 schematically depicts a packaged integrated circuit device 100 ("packaged device 100") having a package configuration of an embodiment. The packaged device 100 of this example includes a package substrate 10, a buffer layer 20, an interposer 30, at least one die 40, and a stiffener 50. In general, this packaged device 100 may be said in this context to have a 2.5D type flip-chip type package arrangement or structure. Fig. 2 depicts a planar (overhead) view of packaged device 100. The depicted overall shape, form factor, positioning of interconnection joints, relative component sizes, numbers of interconnections, solder ball arrangements and/or pitch shown in these depictions are not limiting. Such aspects may be varied as appropriate to intended end use or design preferences.

In general, package substrate 10 can be a wiring substrate or the like with pads, terminals, lands, or the like ("interconnections") for making electrical connections on its upper (in the arbitrary orientation depicted in Fig. 1) surface side 10a ("side 10a") and its lower surface side 10b ("side 10b"). In the present example, package substrate 10 is a wiring substrate in 2.5D type package structure providing connections between L1 interconnections (interposer to package substrate connections) and L2 interconnections (package substrate to device board/socket terminals connections). In other examples, package substrate 10 may be a substrate of another type in a different type of package structure. For example, package substrate 10 may be a panel, a board, a circuit board, or the like without limitation. One or more internal wiring layer of package substrate 10 connects interconnections on side 10a to those on side 10b. The side 10a has solder balls 12 (also called bumps) thereon, which permit the packaged device 100 to be mounted in a larger device, such as a computer, a server, a workstation, a circuit board, or the like. In general, the planar size of package substrate 10 is greater than that of the other elements within packaged device 100. In this example, a stiffener 50 is disposed on side 10a of packaged substrate 10 along an outer perimeter region.

Buffer layer 20 is disposed on side 10a in a central region of packaged substrate 10. Buffer layer 20 provides electrical connections between package substrate 10 and interposer 30. Buffer layer 20. Buffer layer 20 can have physical properties that are distinct from package substrate 10 and interposer 30. For example, buffer layer 20 may differ from package substrate 10 and interposer 30 in modulus of elasticity and/or coefficient of thermal expansion (CTE). The buffer layer 20 has interconnections 21 on a lower surface side 20b ("side 20b") facing package substrate 10 and interconnections 23 facing interposer 30 on an upper surface side 20a ("side 20a"). Electrical connections between buffer layer 20 and package substrate 10 are solder connections, as are the electrical connections between buffer layer 20 and interposer 30. The buffer layer 20 may be referred to in some examples as a buffering layer, a spacing layer, a spacer layer, and/or a layer.

As depicted, buffer layer 20 as feed-through-vias 25 ("through-vias 25") between each corresponding pair of interconnections 21 and 23. In some examples, a relatively simple or basic redistribution (wiring) layer might be incorporated in buffer layer 20 for connection matching between pads on package substrate 10 and interposer 30. In the present example, the construction of buffer layer 20 is kept simple in design to limit costs associated with incorporation of buffer layer 20.

Interposer 30 provides connections between pads (interconnections) on its lower surface side 30b ("side 30b") and pads (interconnections) on its upper surface side 30a ("side 30a"). Interposer 30 may be a silicon interposer, an organic interposer, a reconstituted wafer (RW) interposer, a glass interposer, or the like. Multiple wiring layers may be present in or on interposer 30. In some examples, interposer 30 may incorporate various embedded components (e.g., resistors, capacitors, circuit elements, etc.) and local interconnects. Circuit element 35 in Fig. 1 represents the inclusion of embedded components and wiring layers within interposer 30 in this example. The planar area of interposer 30 is generally less than that of package substrate 10, often less than twice as large as that of package substrate 10 (or packaged device 100) overall. Relatedly, as seen in Fig. 2, the planar dimensions of interposer 30 in a planar axis direction can be substantially less than that of package substrate 10. For example, the maximum x-axis dimension of packaged device 100 may be greater than 100 mm the maximum x-axis dimension of interposer 30. With such differences in dimensions to go along with differences in materials, there may be a significant challenge to maintaining of mechanical integrity of interconnection joints as well as maintaining overall flatness of packaged device 100 across various thermal conditions of the manufacturing and assembly cycle.

On an upper surface side 30a ("side 30a") of interposer 30 one or more die 40 is disposed. Fig. 1 shows three different die 40 (die 40a, die 40b, die 40c) mounted on side 30a of interposer 30. There is no particular limitation with respect to the number of dies 40 that might be utilized in this context. There may be three, less than three, or more than three die 40 depending on end use applications and the like. Likewise, the planar shapes, relative sizes, positioning, arrangements, and the like for each die 40 is not limited to the depicted example(s).

In general, each die 40 is an integrated circuit device. In some contexts, a die 40 may be referred to as a chip, a microchip, a unit, a semiconductor device, or the like. Die 40 may be, without limitation, a processor, a complementary metal oxide semiconductor (CMOS) chip, a memory chip, an application specific integrated circuit (ASIC) chip, graphics processing unit, digital signal processor, or the like. When multiple dies 40 are provided, each may be a different type or the same type. That is, for example, die 40b may be an ASIC chip, and die 40a and die 40c may be memory chips. Alternatively, each of die 40a, 40b, and 40c may be the same type of chip or unit.

Fig. 1 shows a stiffener 50 that is adhered to side 10a of package substrate 10 by resin, adhesive, or solder. Fig. 2 shows that stiffener 50 is provided as unitary rectangular frame-like element surrounding the outer periphery of buffer layer 20. However, this is for example only. Stiffener 50 may be provided in different parts (sub-parts) rather than as unitary element. Additionally, stiffener 50 need not fully surround the outer periphery of buffer layer 20 (or any other internal element of packaged device 100) but may be provided only on certain sides/edges of package substrate 10 in some examples. Furthermore, inclusion of stiffener 50 may be optional in some examples. That is, stiffener 50 would not necessarily be present or included in all embodiments. In general, the inclusion, size, shape, positioning, composition, materials, and the like of stiffener 50 can be selected as appropriate in view of the requirements for stiffness and/or flatness in packaged device 100.

Fig. 1 additionally shows inclusion of a resin 72 between package substrate 10 and buffer layer 20, a resin 74 between buffer layer 20 and interposer 30, a resin 76 between die 40 and interposer 40, and a resin 78 covering substantially all elements on side 10a of package substrate 10. Resins 72 and 74 may be referred to in some context as underfill resins. Resin 76 may comprise an underfill type resin and/or an encapsulating resin. Resin 76 may cover an upper surface side of die 40 in some examples. Resin 78 may be referred to as an encapsulating resin, a potting resin or the like. The upper limit of resin 78 is depicted in Fig. 1 with a dashed line. This is to indicate the possible variability in its positioning in addition to its optionality. The upper limit of resin 78 may be above, at, or below the level of the upper surface of dies 40 and/or resin 76.

One or more of these various resins may be optional (and thus not included) in some examples. It may be desirable for buffer layer 20 to be slightly larger in planar size as compared to the planar size of interposer 30 to permit underfill filling of resin 74 at the interface between side 30b and side 20a. The gap between the outer edge of interposer 30 and the outer edge of buffer layer 20 may be filled or covered with resin 74 or the like. For example, this gap may be approximately 1 millimeter (mm) in dimension. Similarly, the position of stiffener 50 relative the outer edge of side 10a may differ from those depicted in Fig. 1 and Fig. 2.

Additional components may be provided as a part of packaged device 100 for thermal management or other purposes. For example, a heat dissipation structure may be adopted for maintaining optimal or permissible operating temperatures. A "lid" type element may be provided on or at an upper surface packaged device 100. Such a lid type element may be related to stiffness control, environmental control, and/or thermal management.

### Buffer Layer 20

In the related art, packaged integrated circuit devices lack a buffer layer 20 or the like. As such, stresses resulting from CTE mismatch or otherwise between an interposer 30 type element and a package substrate 10 type element may cause dislocation at the interconnections therebetween and/or increase internal stresses/strains in the interposer plus die configuration (also referred to as a "Chip-on-Wafer interposer" or "CoW interposer"). However, selection of a buffer layer 20 material and/or design to provide an effective CTE that is between those of interposer 30 and package substrate 10 may provide lower internal stresses in the CoW interposer. When the buffer layer 20 has a high modulus of elasticity along with a moderate (intermediate) CTE, overall dimensional stability and flatness for packaged device 100 may be provided in a manner that limits internal forces applied to the CoW interposer during temperature changes or otherwise. The forces applied to the interconnections 21 and 23 can also be lower than those that would otherwise occur at direct interconnections between an interposer 30 type element and package substrate 10 type element without the inclusion of buffer layer 20.

In some examples, a buffer layer 20 with a CTE value in a range of 5 parts per million (ppm) to 15 ppm may be considered an intermediate CTE value in comparison to normal CTE values of interposer 30 type elements and package substrate 10 type elements. A Young's modulus value for buffer layer 20 in a range of 25 gigapascals (GPa) to 500 GPa may likewise be appropriate in view of typical modulus values of other components in packaged device 100. The buffer layer 20 may be a low-CTE glass, a lower-temperature co-fired ceramic, a metal, a metal alloy, a resin, a resin reinforced with glass fibers or fabric, and combinations of such media. For example, buffer layer 20 may have a thickness of between 50 microns and 500 microns. While depicted in Fig. 1 as a single material with through-vias 25 passing therethrough, the buffer layer 20 may comprise layers of different materials and/or multiple discrete layers of the same material. The bump (interconnection) pitches on both side 20a and side 20b of buffer layer are generally equivalent to those of an L1 bump pitch in a regular 2.5D device package, for example, about 100 to 200 microns. However, buffer layer 20 may alternatively incorporate one or more redistribution layers for pad matching or the like.

In some examples, it may be preferrable that the buffer layer 20 be formed as a part of a larger panel from which multiple buffer layers 20 and/or multiple packaged devices 100 may be sub-divided during manufacturing. Buffer layers 20 and the materials from which buffer layers 20 are formed preferably have good dimensional stability, flat surfaces, and low total thickness variations along with the relevant CTE and modulus characteristics.

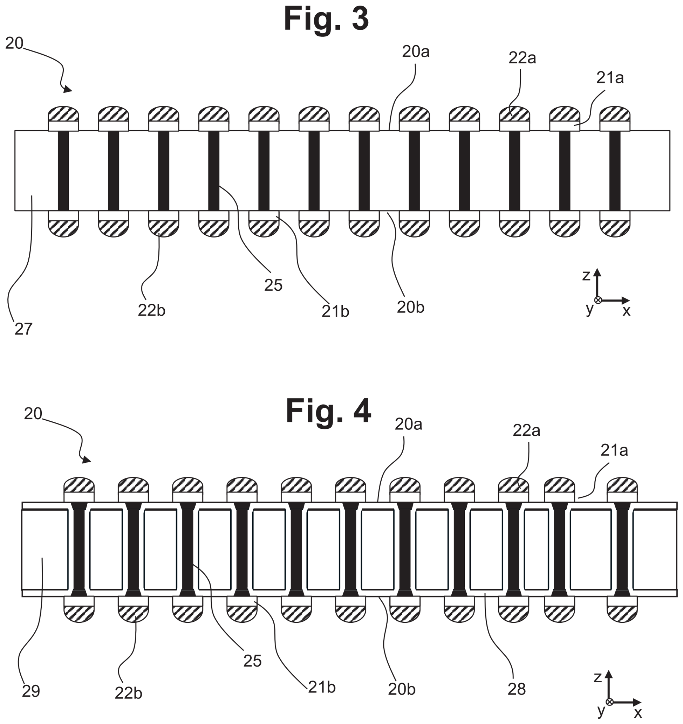

Fig. 3 depicts a buffer layer 20 of a first example. Buffer layer 20 in this example has several through-vias 25 spaced at uniform pitch along the depicted x-axis direction. In general, through-vias 25 are also provided spaced along the depicted y-axis direction. On side 20a, pads 21a are present. On side 20b, pads 21b are present. Through-vias 25 extend from a pad 21a to an opposite pad 21b in a substantially vertical direction (z-axis direction in Fig. 3) as a continuous column of conductive material. Buffer layer 20 is shown with solder bumps 22a and solder bumps 22b disposed, respectively, on the pads 21a and the pads 21b. At various stages of assembly, solder bumps 22a and/or solder bumps 22b may be absent or merged with the interconnections to interposer 30 or package substrate 10.

The material 27 of buffer layer 20 surrounding the through-vias 25 in Fig. 3 is an electrically insulating material. Material 27 forms the bulk of buffer layer 20 in this example. For example, material 27 is a ceramic, a glass, a resin, a glass reinforced resin, or the like. Material 27 may comprise a plurality of different layers stacked in the z-axis direction. Material 27 in some examples may vary in composition region to region within buffer layer 20. For example, material 27 in an edge or peripheral region of buffer layer 20 may differ from material 27 in a central region of buffer layer 20.

The through-vias 25 are electrically conductive, but isolated from each other by the surrounding material 27. For example, the through-vias 25 may be a metal such as copper, tungsten, tantalum, or aluminum. While depicted in Fig. 3 as unitary elements, individual through-vias 25 may comprise multiple components, pieces, portions, or the like. For example, a through-via 25 may comprise multiple layers, one upon the other in a generally radial direction (e.g., in a buffer layer planar direction) or stacked one upon the other in a generally columnar direction (e.g., in a buffer layer thickness direction) corresponding to the depicted z-axis direction. While depicted in Fig. 3 as having a uniform width, through-vias 25 may have other cross-sectional shapes, such as trapezoidal. In the present example, through-vias 25 are columnar shapes and each has a circular cross-sectional shape in the plane of buffer layer 20, but other planar cross-sectional shapes are possible such as, without limitation, square, rectangular, polygonal, oval, or irregular. Individual through-vias 25 may have different cross-sectional shapes at different positions/depths along the buffer layer 20 thickness dimension (z-axis direction in Fig. 3). Within a buffer layer 20, there is no requirement that all through-vias 25 be uniform in shape, size, material, or otherwise, though they may be.

Similarly, pitch (spacing intervals) between through-vias 25 may vary across the buffer layer 20. In some regions, density (packing) of through-vias 25 may be higher than in other regions of buffer layer 20. Some regions of buffer layer 20 may have no through-vias 25 therein. The thickness of buffer layer 20 need not be uniform in all regions and may vary region to region. For example, peripheral or edge regions without through-vias 25 may be thinner or thicker than interior regions with through-vias 25. Arrangements of through-vias 25 may be arbitrary, though generally arrangements will correspond to terminals/pads on interposer 30 and/or package substrate 10. As noted previously, a buffer layer 20 may incorporate one or more redistribution layers to connect through-vias 25 to pads 21a and/or pads 21b.

Fig. 4 depicts a buffer layer 20 of a second example. Buffer layer 20 in this example, like the first example, has several through-vias 25 spaced at substantially uniform pitch along the depicted x-axis direction. In general, through-vias 25 are also provided spaced along the depicted y-axis direction as well. On side 20a, pads 21a are present. On side 20b, pads 21b are present. Through-vias 25 extend from a pad 21a to an opposite pad 21b. Buffer layer 20 is shown with solder bumps 22a and solder bumps 22b. At various stages of assembly, solder bumps 22a and/or solder bumps 22b may be absent or merged with interconnections to interposer 30 or package substrate 10. Unlike in the first example, the bulk of buffer layer 20 as depicted in Fig. 4 is a metallic material 29, also referred to in some contexts as a metallic core material or the like. For example, metallic material 29 may be, without limitation, a conductive material such as molybdenum, a molybdenum alloy, titanium, a titanium alloy, or an iron-nickel-cobalt alloy. For example, metallic material 29 may be an iron-nickel cobalt material that is vacuum melted to have a chemical composition controlled to be within narrow limits to provide uniform thermal expansion properties or the like. Since metallic material 29 is electrically conductive, it is necessary to incorporate an insulating material 28 to prevent electrical shorting across through-vias 25 (and pads 21a/21b). Metallic material 29 may comprise a plurality of different layers stacked in the z-axis direction. Metallic material 29 in some examples may vary in composition, or otherwise, region to region within buffer layer 20.

The insulating material 28 surrounding the through-vias 25 in Fig. 4 is an electrically insulating material. For example, insulating material 28 can be a dielectric material such as silicon oxide or silicon nitride. Insulating material 28 may comprise a plurality of different layers stacked in the z-axis direction or radially around each through-via 25. Insulating material 28 in some examples may vary in composition region to region within buffer layer 20. That is, for example, insulating material 28 surrounding a through-via 25 may differ in composition and/or dimension from insulating material 28 on side 20a and/or side 20b.

In Fig. 4, the through-vias 25 are isolated from each other (and metallic material 29) by the surrounding insulating material 28. For example, the through-vias 25 may be a metal such as copper or aluminum. While depicted in Fig. 4 as unitary elements, individual through-vias 25 may comprise multiple components, pieces, portions, or the like. For example, a through-via 25 may comprise multiple layers, one upon the other in a generally radial direction (e.g., in a buffer layer planar direction) or stacked one upon the other in a generally columnar direction (e.g., in a buffer layer thickness direction) corresponding to the depicted z-axis direction. While depicted in Fig. 4 as having a uniform width, through-vias 25 may have other cross-sectional shapes, such as trapezoidal. In the present example, through-vias 25 are columnar shapes and each has a circular cross-sectional shape in the plane of buffer layer 20, but other planar cross-sectional shapes are possible such as, without limitation, square, rectangular, polygonal, oval, or irregular. Individual through-vias 25 may have different cross-sectional shapes at different positions/depths along the buffer layer 20 thickness dimension (z-axis direction in Fig. 4). Within a buffer layer 20, there is no requirement that all through-vias 25 be uniform in shape, size, material, or otherwise.

### Methods of Manufacture

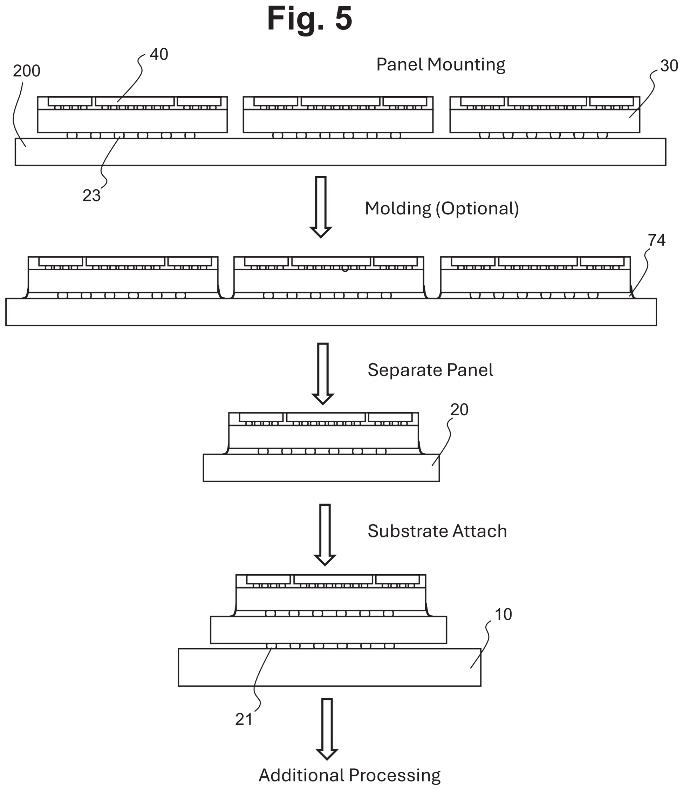

Fig. 5 depicts a manufacturing method for a package configuration of an embodiment. In the method of Fig. 5, a panel 200 is provided. Panel 200 corresponds to several undivided buffer layers 20. While not specifically depicted in Fig. 5, panel 200 has therein through-vias 25 as well as pads 21a and 21b thereon as appropriate such as depicted for individual buffer layers 20 in Fig. 3 or Fig. 4. The buffer layers 20 ultimately provided by sub-division of panel 200 may be of the general type depicted in Fig. 3 or Fig. 4, but is not limited thereto.

At a first stage depicted in Fig. 5, an interposer 30 with one or more die 40 already mounted thereon is joined to the panel 200 by interconnections 23. Interposer 30 is shown in simplified form in Fig. 5 (see, e.g., Fig. 1 for additional interposer 30 details). Solder bumps 22a or the like may be predisposed on the panel 200 in one or more regions corresponding to a buffer layer 20 region. This is repeated until all mounting positions available on the panel 200 are occupied.

Next, a molding process may be optionally performed to provide resin 74 as underfill or the like. Additional resin may fill the gaps between adjacent interposers 30 on the panel 200.

The panel 200 is then separated into individual buffer layer 20 portions by, for example, a dicing, cutting, or scoring process. The buffer layer 20 is depicted in Fig. 5 in a simplified form (see, e.g., Fig. 1, Fig. 3, or Fig. 4 for additional buffer layer 20 details). The panel 200 may be pre-scored, partially cut, and/or initially fabricated in a manner to permit or promote separation. Bumps 22b may already be present on panel 200 or may be added after panel separation into buffer layers 20.

Each now individualized buffer layer 20 is then separately mounted to a package substrate 10 via interconnections 21. The packaged device 100 depicted in Fig. 1 is thus substantially provided. Additional processing steps may be performed to provide resin 72, stiffener 50, and solder balls 12 in a usual manner. In some examples, a stiffener 50 may be present on package substrate 10 prior to mounting of the buffer layer 20. Likewise, solder balls 12 may already be present on package substrate 10 before mounting of buffer layer 20.

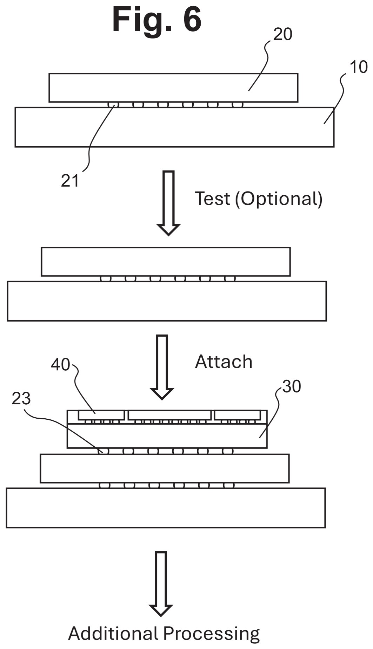

Fig. 6 depicts another manufacturing method for a package configuration of an embodiment. In the method of Fig. 6, no panel 200 is provided or alternatively panel 200 is sub-divided into buffer layers 20 in an initial step. While not specifically depicted in Fig. 6, the buffer layer 20 has the through-vias 25 as well as pads 21a and 21b as appropriate (see, e.g., Fig. 1, Fig. 3, or Fig. 4 for buffer layer 20 details). Bumps 22a and/or 22b may likewise have already been provided on the buffer layer 20. The buffer layer 20 may be of the general type depicted in Fig. 3 or Fig. 4, but is not limited thereto.

In the method of Fig. 6, a buffer layer 20 is mounted to a package substrate 10 at the initial step. A molding processing may be optionally performed at this point to provide resin 72 as underfill or the like. Next, an electrical test step can be optionally performed to validate the connectivity of the interconnections 21 between the mounted buffer layer 20 and the underlying package substrate 10. The testing may also serve to validate the construction of buffer 20 and/or package substate 10 prior to mounting of interposer 30.

Next, an interposer 30 is mounted on to buffer layer 20 via interconnections 23. Fig. 6 depicts the dies 40 already mounted on the interposer 30 prior to the mounting of interposer 30 to the buffer layer 20. In other examples, one or more dies 40 may be mounted on the interposer 30 after interposer 30 is mounted on buffer layer 20. Interposer 30 is depicted in Fig. 6 in a simplified form (see, e.g., Fig. 1 for additional interposer 30 details). The packaged device 100 depicted in Fig. 1 is thus substantially provided.

Additional processing steps may be performed to provide resin 72, resin 74, stiffener 50, and solder balls 12 in a usual manner. In some examples, a stiffener 50 may be present on package substrate 10 prior to mounting of the buffer layer 20 or before the mounting of interposer 30. Likewise, solder balls 12 may already be present on package substrate 10 before mounting of buffer layer 20 or interposer 30.

In general, ordering of steps or processing in above-described methods may be varied to the extent technologically feasible and the described examples are not limiting with respect to possible manufacturing methods that may be adopted for the manufacturing of a packaged device 100.

One or more embodiments of the present invention may be implemented in conjunction with one or more computer programs or as one or more computer program modules embodied in computer readable media. The term computer readable medium refers to any data storage device that can store data which can thereafter be input to a computer system. Computer readable media may be based on any existing or subsequently developed technology that embodies computer programs in a manner that enables a computer to read the programs. Examples of computer readable media are hard drives, network-attached storage (NAS) systems, read-only memory (ROM), RAM, compact disks (CDs), digital versatile disks (DVDs), magnetic tapes, and other optical and non-optical data storage devices. A computer readable medium can also be distributed over a network-coupled computer system so that the computer readable code is stored and executed in a distributed fashion.

Although one or more embodiments of the present disclosure have been described in some detail for clarity of understanding, certain changes may be made and still be within the scope of the claims. Accordingly, the described embodiments are to be considered as illustrative and not restrictive or limiting, and the scope of the claims is not to be considered limited to details given herein but may be modified while still being within the scope of the claims and equivalents. In the claims, any recitation of elements and/or steps do not imply any particular order of operation or incorporation unless explicitly stated in the claims.

Depicted boundaries between components, elements, devices, and units are somewhat arbitrary, and while particular boundaries may have been illustrated in the context of specific example configurations, other boundaries, divisions, and/or allocations of functions, components, elements, or aspects may be possible or available. Such other allocations of functionality and/or components are envisioned and should be considered to fall within the scope of the present disclosure. In general, structures and functionalities presented as separate components in exemplary configurations may be implemented as a combined structure or component. Similarly, structures and functionalities presented as a single component may be implemented as separate components. These and other variations, additions, alterations, and improvements may fall within the scope of the appended claims.

The following are further embodiments of the invention:
1. A packaged integrated circuit device, comprising:
   a package substrate;
   a layer disposed on the package substrate;
   an interposer disposed on the layer; and
   a die disposed on the interposer, wherein
   the layer has a coefficient of thermal expansion that is between a coefficient of thermal expansion of the interposer and a coefficient of thermal expansion of the package substrate.
2. The packaged integrated circuit device of embodiment 1, further comprising:
   a plurality of die disposed on the interposer.
3. The packaged integrated circuit device of embodiment 1, wherein the layer has a Young's modulus value in the range of 25 GPa to 500 GPa.
4. The packaged integrated circuit device of embodiment 1, wherein
   the package substrate has a plurality of first pads on a first surface facing the layer,
   the interposer has a plurality of second pads on a second surface facing the layer,
   the layer has a plurality of third pads on a third surface facing the package substrate and a plurality of fourth pads on a fourth surface facing the interposer substrate,
   the plurality of first pads are respectively electrically connected to the plurality of third pads, and
   the plurality of second pads are respectively electrically connected to the plurality of fourth pads.
5. The packaged integrated circuit device of embodiment 4, wherein
   the first pads are electrically connected to the third pads by solder balls, and
   the second pads are electrically connected to the fourth pads by solder balls.
6. The packaged integrated circuit device of embodiment 4, wherein the layer comprises a plurality of through-vias extending between corresponding pairs of the third and fourth pads.
7. The packaged integrated circuit device of embodiment 6, wherein the layer comprises an insulating core material through which the plurality of through-vias pass.
8. The packaged integrated circuit device of embodiment 6, wherein
   the layer comprises a metallic core material through which the plurality of through-vias pass, and
   an insulating material surrounds each of the through-vias to electrically insulate each of the plurality of through-vias from the metallic core material.
9. The packaged integrated circuit device of embodiment 8, wherein
   the insulating material is on the third and fourth surface, and
   the insulating material electrically insulates the metallic core material from the plurality of third pads and the plurality of fourth pads.
10. The packaged integrated circuit device of embodiment 6, wherein the through-vias extend in a direction substantially orthogonal to a plane of the layer parallel to the third and fourth surfaces.
11. The packaged integrated circuit device of embodiment 1, further comprising:
   a stiffener element on the package substrate at position outside the layer.
12. A flip-chip packaged integrated circuit device, comprising:
   a package substrate having first pads on a first surface and second pads on a second surface, the first pads being electrically connected to the second pads by one or more wiring layers of the package substrate;
   a layer mounted on the package substrate and having third pads on a third surface facing the package substrate and fourth pads on a fourth surface facing away from the package substrate, a plurality of through-vias extending in the layer from the third surface to fourth surface to electrically connect the third pads to the fourth pads;
   an interposer mounted on the layer and having fifth pads on a fifth surface facing the layer and sixth pads on a sixth surface facing away from the layer, the interposer incorporating therein one or more wiring layers electrically connecting the fifth pads to the sixth pads; and
   a first die mounted on the interposer and having a seventh pad facing the interposer and electrically connected to at least one of the first pads of the package substrate via at least one the plurality of through-vias.
13. The flip-chip packaged integrated circuit device according to embodiment 12, wherein the layer has a coefficient of thermal expansion that is between a coefficient of thermal expansion of the interposer and a coefficient of thermal expansion of the package substrate.
14. The flip-chip packaged integrated circuit device according to embodiment 12, further comprising:
   a second die mounted on the interposer.
15. The flip-chip packaged integrated circuit device according to embodiment 14, wherein
   the first die is an application specific integrated circuit, and
   the second die is a memory unit.
16. The flip-chip packaged integrated circuit device according to embodiment 12, wherein
   a planar area of the package substrate is greater than a planar area of layer, and
   a planar area of the interposer is less than the planar area of the layer.
17. The flip-chip packaged integrated circuit device according to embodiment 12, wherein the second pads, the third pads, the fourth pads and the fifth pads are substantially aligned with one another along a direction parallel to an extension direction of the through-vias between the third and fourth surfaces of the layer.
18. The flip-chip packaged integrated circuit device according to embodiment 12, wherein a bulk material of the layer is a metallic material.
19. The flip-chip packaged integrated circuit device according to embodiment 12, wherein a bulk material of the layer is an insulating material.
20. A method of manufacturing a packaged integrated circuit device, the method comprising:
   mounting a layer on a package substrate, the package substrate having first pads on a first surface and second pads on a second surface, the first pads being electrically connected to the second pads by one or more wiring layers of the package substrate, the layer having third pads on a third surface facing the package substrate and fourth pads on a fourth surface facing away from the package substrate, a plurality of through-vias extending in the layer from the third surface to fourth surface to electrically connect the third pads to the fourth pads;
   mounting an interposer on the layer, the interposer having fifth pads on a fifth surface facing the layer and sixth pads on a sixth surface facing away from the layer, the interposer incorporating therein one or more wiring layers electrically connecting the fifth pads to the sixth pads; and
   mounting a die on the interposer.

## Claims

1. A packaged integrated circuit device, comprising:
a package substrate;
a layer disposed on the package substrate;
an interposer disposed on the layer; and
a die disposed on the interposer, wherein
the layer has a coefficient of thermal expansion that is between a coefficient of thermal expansion of the interposer and a coefficient of thermal expansion of the package substrate.

2. The packaged integrated circuit device of claim 1, further comprising:
a plurality of die disposed on the interposer,
and/or
a stiffener element on the package substrate at position outside the layer.

3. The packaged integrated circuit device of claim 1 or 2, wherein the layer has a Young's modulus value in the range of 25 GPa to 500 GPa.

4. The packaged integrated circuit device of one of the previous claims, wherein
the package substrate has a plurality of first pads on a first surface facing the layer, the interposer has a plurality of second pads on a second surface facing the layer,
the layer has a plurality of third pads on a third surface facing the package substrate and a plurality of fourth pads on a fourth surface facing the interposer substrate,
the plurality of first pads are respectively electrically connected to the plurality of third pads, and
the plurality of second pads are respectively electrically connected to the plurality of fourth pads,
in particular,
wherein
the first pads are electrically connected to the third pads by solder balls, and
the second pads are electrically connected to the fourth pads by solder balls.

5. The packaged integrated circuit device of claim 4, wherein the layer comprises a plurality of through-vias extending between corresponding pairs of the third and fourth pads,
in particular,
wherein the layer comprises an insulating core material through which the plurality of through-vias pass.

6. The packaged integrated circuit device of claim 5, wherein
the layer comprises a metallic core material through which the plurality of through-vias pass, and
an insulating material surrounds each of the through-vias to electrically insulate each of the plurality of through-vias from the metallic core material,
in particular,
wherein
the insulating material is on the third and fourth surface, and
the insulating material electrically insulates the metallic core material from the plurality of third pads and the plurality of fourth pads.

7. The packaged integrated circuit device of claim 5, wherein the through-vias extend in a direction substantially orthogonal to a plane of the layer parallel to the third and fourth surfaces.

8. A flip-chip packaged integrated circuit device, comprising:
a package substrate having first pads on a first surface and second pads on a second surface, the first pads being electrically connected to the second pads by one or more wiring layers of the package substrate;
a layer mounted on the package substrate and having third pads on a third surface facing the package substrate and fourth pads on a fourth surface facing away from the package substrate, a plurality of through-vias extending in the layer from the third surface to fourth surface to electrically connect the third pads to the fourth pads;
an interposer mounted on the layer and having fifth pads on a fifth surface facing the layer and sixth pads on a sixth surface facing away from the layer, the interposer incorporating therein one or more wiring layers electrically connecting the fifth pads to the sixth pads; and
a first die mounted on the interposer and having a seventh pad facing the interposer and electrically connected to at least one of the first pads of the package substrate via at least one the plurality of through-vias.

9. The flip-chip packaged integrated circuit device according to claim 8, wherein the layer has a coefficient of thermal expansion that is between a coefficient of thermal expansion of the interposer and a coefficient of thermal expansion of the package substrate.

10. The flip-chip packaged integrated circuit device according to claim 8 or 9, further comprising:
a second die mounted on the interposer.

11. The flip-chip packaged integrated circuit device according to claim 10, wherein
the first die is an application specific integrated circuit, and
the second die is a memory unit.

12. The flip-chip packaged integrated circuit device according to one of claims 8 to 11, wherein
a planar area of the package substrate is greater than a planar area of layer, and
a planar area of the interposer is less than the planar area of the layer.

13. The flip-chip packaged integrated circuit device according to one of claims 8 to 12, wherein the second pads, the third pads, the fourth pads and the fifth pads are substantially aligned with one another along a direction parallel to an extension direction of the through-vias between the third and fourth surfaces of the layer,
and/or
wherein a bulk material of the layer is a metallic material.

14. The flip-chip packaged integrated circuit device according to one of claims 8 to 13, wherein a bulk material of the layer is an insulating material.

15. A method of manufacturing a packaged integrated circuit device, the method comprising:
mounting a layer on a package substrate, the package substrate having first pads on a first surface and second pads on a second surface, the first pads being electrically connected to the second pads by one or more wiring layers of the package substrate, the layer having third pads on a third surface facing the package substrate and fourth pads on a fourth surface facing away from the package substrate, a plurality of through-vias extending in the layer from the third surface to fourth surface to electrically connect the third pads to the fourth pads;
mounting an interposer on the layer, the interposer having fifth pads on a fifth surface facing the layer and sixth pads on a sixth surface facing away from the layer, the interposer incorporating therein one or more wiring layers electrically connecting the fifth pads to the sixth pads; and
mounting a die on the interposer.
